**Europäisches Patentamt**

**European Patent Office**

**Office européen des brevets**

(19)

(11) Veröffentlichungsnummer : **0 185 263**
**B1**

(12) **EUROPÄISCHE PATENTSCHRIFT**

(45) Veröffentlichungstag der Patentschrift :
**27.07.88**

(51) Int. Cl.⁴ : **G 03 B 41/00**

(21) Anmeldenummer : **85115482.3**

(22) Anmeldetag : **05.12.85**

(54) Einrichtung zur optischen Abbildung zweier in verschiedenen Objektebenen angeordneter Objekte.

(30) Priorität : **20.12.84 DE 3446584**

(43) Veröffentlichungstag der Anmeldung :
**25.06.86 Patentblatt 86/26**

(45) Bekanntmachung des Hinweises auf die Patenterteilung : **27.07.88 Patentblatt 88/30**

(84) Benannte Vertragsstaaten :
**DE FR GB**

(56) Entgegenhaltungen :
**FR-A- 2 371 716**
**US-A- 3 511 149**
**SIEMENS FORSCHUNGS- UND ENTWICKLUNGSBE-**
**RICHTE, Band 13, Nr. 2, 1984, Seiten 43-47, Springer-**
**Verlag, Berlin, DE; G. DOEMENS et al.: "Automatic**
**mask alignment for X-ray microlithography"**

(73) Patentinhaber : **Siemens Aktiengesellschaft Berlin**
**und München**
**Wittelsbacherplatz 2**
**D-8000 München 2 (DE)**

(72) Erfinder : **Eigenstetter, Herbert**
**Alex-Fleming-Strasse 107**
**D-8033 Planegg (DE)**
Erfinder : **Mengel, Peter, Dr.**
**Roggensteinerallee 32**
**D-8031 Eichenau (DE)**

## Beschreibung

Die Erfindung betrifft eine Einrichtung zur optischen Abbildung zweier in verschiedenen Objektebenen angeordneter Objekte auf einen optischen Sensor, bei welcher zumindest ein Objektiv mit Hilfe eines Stellantriebes relativ zu den Objektebenen verstellbar ist.

In der Halbleitertechnik werden mit Hilfe von Masken feinste Strukturen auf Halbleiterscheiben übertragen, wobei eine hochgenaue Justierung von Maske zu Scheibe verlangt wird. So erfordert beispielsweise die Übertragung von Strukturen im Submikrometerbereich durch die Röntgenlithografie eine Justierung von Maske zu Scheibe mit Genauigkeiten im Bereich unter 0,1 μm.

Aus der DE-PS 28 22 269 ist ein Verfahren zur automatischen Maskenjustierung bekannt, bei welchem die Justierung aufeinanderfolgender Masken jeweils mit orthogonal zueinander verlaufenden Justierstrukturen auf der mit einem Fotoresist beschichteten Halbleiterscheibe und auf der Maske vorgenommen wird. Die Justierstruktur der Halbleiterscheibe wird bereits im ersten Strukturierungsvorgang auf der Oberfläche der Halbleiterscheibe beispielsweise durch Ätzen erzeugt, so daß bei sämtlichen nachfolgenden Strukturierungsvorgängen die auf der entsprechenden Maske vorhandenen Justierstrukturen in bezug auf diese erste Justierstruktur ausgerichtet werden können. Zur automatischen Maskenjustierung werden dann die Justierstrukturen auf Maske und Scheibe in parallel zu ihren Kanten verlaufenden Richtungen mit Hilfe eines optischen Sensors abgetastet, worauf die Intensität der durch die optoelektronische Abtastung erzeugten Bildsignale zeilenweise oder zeilenabschnittsweise aufintegriert wird und die daraus resultierenden analogen Integralwerte in digitale Graustufen umgewandelt und gespeichert werden. Durch Differenzbildung der Graustufen aufeinanderfolgender Zeilen und weitere Auswertung der resultierenden Differenzsignale kann dann die Lage der Mittelachsen der Justierstrukturen erfaßt werden, worauf dann Halbleiterscheibe und Maske zur Justierung entsprechend dem festgestellten Versatz der Mittellinien gegeneinander verschoben und verdreht werden.

Bei der bekannten Maskenjustierung auf der Basis von Mustererkennung und Bildverarbeitung an geeigneten Justierstrukturen begrenzt jedoch der Proximityabstand zwischen Maske und Halbleiterscheibe die erzielbare Erkennungs- und Justiergenauigkeit. Wird bei einer mikroskopischen Abbildung beispielsweise die Fokusebene zwischen die Maskenebene und die Scheibenebene gelegt, so sind die Justierstrukturen beider Ebenen nur unscharf auf dem optischen Sensor wiedergegeben. Die Auswertung der dadurch verbreiterten opto-elektronischen Kantensignale für die Bestimmung der Relativlage von Maske und Halbleiterscheibe ist dann nicht eindeutig, d.h. die Genauigkeit der Lageerkennung ist begrenzt.

Bei einer bekannten Einrichtung zur optischen Abbildung der Justierstrukturen von Maske und Halbleiterscheibe auf einen optischen Sensor wird eine Zweiebenen-Optik verwendet, bei welcher durch zwei unterschiedliche optische Weglängen im Strahlengang der abbildenden Optik entweder die Maskenebene oder die Scheibenebene scharf auf den optischen Sensor abgebildet werden kann. Schwankungen im Proximityabstand von Maske und Halbleiterscheibe, Unebenheiten der Scheinenoberfläche und unterschiedliche Dicken des Fotoresists auf der Scheibenoberfläche führen jedoch auch hier zu einer Beeinträchtigung der Schärfe des Bildes der Kantenübergänge in den einzelnen Objektebenen. Die Grenzen der opto-elektronischen Grauwertbildverarbeitung lassen sich demgegenüber nur dann erreichen, wenn bei der Bilderfassung die Justierstrukturen von Maske und Halbleiterscheibe eindeutig scharf auf den optischen Sensor abgebildet werden.

In der Zeitschrift « Siemens Forsch.- u. Entwickl.-Ber. » Bd. 13 (1984) Nr. 2, Seiten 43 bis 47, sind bereits die Probleme angesprochen, die sich bei der automatischen Maskenjustierung für die Röntgenlithografie durch Schwankungen im Proximityabstand von Maske und Scheibe ergeben. Diese Probleme sollen dabei dadurch gelöst werden, daß für die optische Abbildung der Justierstrukturen eine Beleuchtungsapertur verwendet wird, welche im Verhältnis zur Objektivapertur gering ist. Gemäß einem alternativen Lösungsvorschlag soll das Objektiv mit Hilfe eines Piezostellantriebes so verstellt werden können, daß einmal die Justierstruktur der Maske und das andere Mal die Justierstruktur der Halbleiterscheibe scharf auf den optischen Sensor abgebildet wird. Hierbei ist es jedoch von ausschlaggebender Bedeutung, daß das Objektiv absolut shiftfrei verstellt werden kann.

Der Erfindung liegt die Aufgabe zugrunde, eine Einrichtung zur optischen Abbildung zweier in verschiedenen Objektebenen angeordneter Objekte auf einen optischen Sensor zu schaffen, bei welcher zur Scharfstellung zumindest ein Objektiv mit Hilfe eines Stellantriebes relativ zu den Objektebenen abso-lut shiftfrei und mit einer sehr hohen Positionierwiederholbarkeit verstellt werden kann.

Diese Aufgabe wird bei einer gattungsgemäßen Einrichtung dadurch gelöst, daß der Stellantrieb an einem ortsfesten Gehäuse abgestützt ist und an einem relativ zu den Objektebenen verstellbaren und zumindest das Objektiv tragenden Gehäuseabschnitt angreift, daß das ortsfeste Gehäuse und der verstellbare Gehäuseabschnitt einstückig ausgebildet sind und daß der verstellbare Gehäuseabschnitt mit dem ortsfesten Gehäuse über symmetrisch zur optischen Achse angeordneten Federgelenken verbunden ist, die durch elastisch deformierbare Schwachstellen des Gehäuses gebildet sind.

Der Erfindung liegt die Erkenntnis zugrunde,

daß eine absolut shiftfreie Verstellung des Objektivs mit der geforderten hohen Positionierwiederholbarkeit nur dann erreicht werden kann, wenn das Objektiv zusammen mit dem Gehäuseabschnitt verstellt wird, in oder an dem es starr befestigt ist. Eine wesentliche Voraussetzung ist dabei, daß die für die Verstellbarkeit dieses Gehäuseabschnitts erforderlichen Federgelenke durch elastisch deformierbare Schwachstellen des Gehäuses gebildet sind, d.h., daß der verstellbare Gehäuseabschnitt mit dem übrigen ortsfest angeordneten Gehäuse über die Federgelenke einstückig verbunden sein muß. Nur durch eine derartige einstückige Herausbildung der Federgelenke aus dem Gehäuse können gleiche Eigenschaften sämtlicher Federgelenke gewährleistet werden. Zudem ist der an dem verstellbaren Gehäuseabschnitt angreifende Stellantrieb am ortsfesten Gehäuse abgestützt, was in einfacher Weise über eine in den verstellbaren Gehäuseabschnitt ragende Rippe des ortsfesten Gehäuses geschieht.

Gemäß einer besonders bevorzugten Ausgestaltung der Erfindung sind mindestens vier, paarweise auf gegenüberliegenden Seiten des verstellbaren Gehäuseabschnitts angeordnete Federgelenke vorgesehen. Durch eine derartige paarweise Anordnung von mindestens vier Federgelenken kann die geforderte shiftfreie Verstellung des verstellbaren Gehäuseabschnitts besonders einfach realisiert werden.

Weiterhin ist es besonders vorteilhaft, wenn jedes Federgelenk durch zwei im Abstand zueinander angeordnete Schwachstellen gebildet ist, wobei jede Schwachstelle durch auf gegenüberliegenden Seiten in die Wandung des Gehäuses eingebrachte Nuten gebildet ist. Durch die Möglichkeit die Nuten mit höchster Präzision in die Wandung des Gehäuses einzubringen, können die Federlängen und die wirksamen Querschnitte der Federgelenke mit entsprechend hoher Präzision vorgegeben werden, was zu einer hohen Reproduzierbarkeit des Kraft-Weg-Verhaltens des verstellbaren Gehäuseabschnitts führt. Die Nuten weisen vorzugsweise einen halbkreisförmigen Querschnitt auf, da durch diese Querschnittsform eine unerwünschte Konzentration örtlicher Biegespannungen vermieden wird.

Gemäß einer weiteren Ausgestaltung der Erfindung sind zwischen den verstellbaren Gehäuseabschnitt und das übrige Gehäuse Trennschlitze eingebracht, die sich jeweils zwischen zwei Federgelenken erstrecken. Das Einbringen derartiger Trennschlitze ermöglicht auf besonders einfache Weise die Beweglichkeit des verstellbaren Gehäuseabschnitts.

Für Verstellwege des verstellbaren Gehäuseabschnitts im Submikrometerbereich hat es sich als besonders zweckmäßig herausgestellt, wenn als Stellantrieb ein Piezostellantrieb vorgesehen ist. Bei derartigen Piezostellantrieben kann beispielsweise einer Verstellspannung von 1 V ein Verstellweg von 1/100 μm zugeordnet werden.

Gemäß einer weiteren besonders bevorzugten Ausgestaltung der Erfindung ist ein Objektiv mit unendlicher Bildweite vorgesehen, welchem eine von dem ortsfest angeordneten Gehäuse getragene Tubuslinse nachgeschaltet ist. Der Vorteil der Verwendung eines Objektivs mit unendlicher Bildweite liegt im parallelen Strahlengang zwischen Objektiv und Tubuslinse. Insbesondere wird dann durch eine Verstellung des Objektivs die Gesamtvergrößerung der Einrichtung nicht verändert.

Schließlich ist es für die automatische Maskenjustierung besonders günstig, wenn die Objekte in zwei räumlich getrennten Gesichtsfeldern über zwei Objektive auf zwei optische Sensoren abbildbar sind, wobei der Stellantrieb mittig zwischen den optischen Achsen an dem beide Objektive tragenden verstellbaren Gehäuseabschnitt angreift. Da die Maskenjustierung sowohl translatorische als auch rotatorische Positionsbewegungen erfordert, bringt die Aufteilung in zwei im Abstand zueinander angeordnete Gesichtsfelder erhebliche Vorteile. Außerdem kann der Stellantrieb dann auf einfache Weise so zwischen den optischen Achsen der beiden Objektive angeordnet werden, daß sich eine besonders kompakte Bauweise der gesamten Einrichtung ergibt.

Ein Ausführungsbeispiel der Erfindung ist in der Zeichnung dargestellt und wird im folgenden näher beschrieben.

Es zeigen :

Figur 1 die prinzipielle Wirkungsweise der automatischen Maskenjustierung,

Figur 2 eine Vorderansicht einer Einrichtung zur optischen Abbildung der Justierstrukturen von Maske und Halbleiterscheibe auf einen optischen Sensor und

Figur 3 eine Draufsicht auf die in Figur 2 dargestellte Einrichtung.

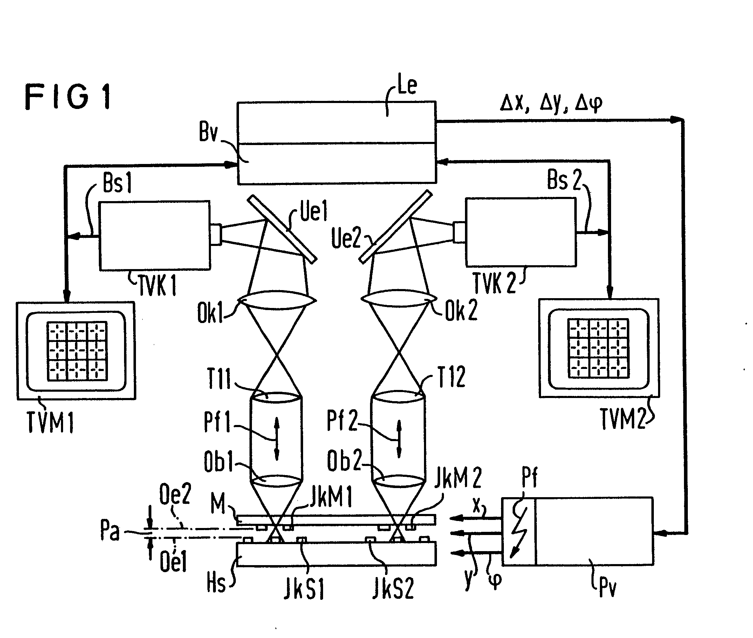

In Figur 1 ist eine Halbleiterscheibe Hs dargestellt, auf welche durch Röntgenlithografie feinste Strukturen im Submikrometerbereich übertragen werden sollen. Die für diese Strukturübertragungen erforderlichen Masken M müssen mit Genauigkeiten im Bereich unter 0,1 μm in bezug auf die Halbleiterscheibe Hs justiert werden, wobei eine derartig präzise Justierung nicht mehr visuell, sondern nur noch automatisch vorgenommen werden kann. Für die gegenseitige Ausrichtung von Maske M zu Halbleiterscheibe Hs sind orthogonal zueinander verlaufende Justierstrukturen vorgesehen, die an zwei im Abstand zueinander angeordneten Stellen auf die Maske M und die Halbleiterscheibe Hs aufgebracht und im dargestellten Fall als Justierkreuze ausgebildet sind. Die auf die Halbleiterscheibe Hs aufgebrachten Justierkreuze sind mit JkS1 und JkS2 bezeichnet, während die zugeordneten Justierkreuze auf der Maske M mit JkM1 und JkM2 bezeichnet sind. Zur Vermeidung von Maskenbeschädigungen besteht zwischen der Halbleiterscheibe Hs und der Maske M ein Abstand, d.h. die Justierkreuze JkS1 und JkS2 sind in einer ersten Objektebene Oe1 angeordnet, während die Justierkreuze JkM1 und JkM2 in einer zweiten Objektebene Oe2 angeordnet sind. Der als Proximityabstand Pa bezeichnete Abstand zwischen den Objektebenen Oe1 und Oe2 kann Schwankungen unterliegen, wobei sich diese Schwankungen beispielsweise im Bereich zwischen 30 μm und 50 μm bewegen.

Die Justierkreuze JkS1 und JkM1 werden in parallel zu ihren Kanten verlaufenden Richtungen mit Hilfe eines optischen Sensors abgetastet, welcher im dargestellten Fall als TV-Kamera TVK1 mit elektronischer Bilddrehung um 90° ausgebildet ist. Die durch die opto-elektronische Abtastung erzeugten Bildsignale Bs1 werden dann einerseits einem TV-Monitor TVM1 und andererseits einer Bildverarbeitungseinrichtung Bv zugeführt.

Die optische Abbildung der Justierkreuze JkS1 und JkM1 auf die TV-Kamera TVK1 erfolgt über ein Objektiv Ob1 mit unendlicher Bildweite, eine Tubuslinse Tl1, ein Okular Ok1 und eine als Umlenkspiegel dargestellte Umlenkeinrichtung Ue1, wobei die vorstehend aufgeführten optischen Bauelemente nacheinander im Strahlengang angeordnet sind.

Die Justierkreuze JkS2 und JkM2 werden in parallel zu ihren Kanten verlaufenden Richtungen mit Hilfe eines optischen Sensors abgetastet, welcher im dargestellten Fall als TV-Kamera TVK2 mit elektronischer Bilddrehung um 90° ausgebildet ist. Die durch die oplto-elektronische Abtastung erzeugten Bildsignale Bs2 werden dann einerseits einem TV-Monitor TVM2 und andererseits der bereits erwähnten Bildverarbeitungseinrichtung Bv zugeführt.

Die optische Abbildung der Justierkreuze JkS2 und JkM2 auf die TV-Kamera TVK2 erfolgt über ein Objektiv Ob2 mit unendlicher Bildweite, eine Tubuslinse Tl2, ein Okular Ok2 und eine als Umlenkspiegel dargestellte Umlenkeinrichtung Ue2, wobei die vorstehend aufgeführten optischen Bauelemente nacheinander im Strahlengang angeordnet sind.

Die Intensität der durch die opto-elektronische Abtastung erzeugten Bildsignale Bs1 bzw. Bs2 wird in der Bildverarbeitungseinrichtung Bv zeilenweise oder zeilenabschnittsweise aufintegriert, worauf die resultierenden analogen Integralwerte in digitale Graustufen umgewandelt und gespeichert werden. Durch Differenzbildung der Graustufen aufeinanderfolgender Zeilen und weitere Auswertung der resultierenden Differenzsignale kann dann in einer Lageerkennungseinrichtung Le die Lage der Mittelachsen der Justierkreuze JkS1 und JkM1 bzw. JkS2 und JkM2 erfaßt werden, worauf dann Halbleiterscheibe Hs und Maske M entsprechend dem festgestellten Versatz der Mittellinien gegeneinander verschoben und verdreht werden. Hierzu werden die von der Lageerkennungseinrichtung Le als Stellsignale gebildeten Justiergrößen Δx, Δy und Δφ einer nur schematisch dargestellten Piezoverstellung Pv zugeführt, welche die Verschiebung in zwei zueinander senkrechten Richtungen entsprechend den Pfeilen x und y und die Verdrehung entsprechend dem Pfeil φ bewirkt. Durch den Pfeil Pf soll angedeutet werden, daß die einzelnen Piezostellantriebe der Piezoverstellung Pv durch eine Hochspannung von beispielsweise 1000 V angetrieben werden.

Weitere Einzelheiten der vorstehend beschriebenen automatischen Maskenjustierung auf der Basis von Mustererkennung und Bildverarbeitung an geeigneten Justierstrukturen gehen aus der DE-PS 28 22 269 und aus der Zeitschrift « Siemens Forsch.- u. Entwickl.-Ber. » Bd. 13 (1984) Nr. 2, Seiten 43 bis 47, hervor.

Bei der bekannten Maskenjustierung begrenzt der Proximity-abstand Pa zwischen der Maske M und der Halbleiterscheibe Hs die erzielbare Erkennungs- und Justiergenauigkeit, sofern es nicht durch zusätzliche Maßnahmen bei der Bilderfassung gelingt, die Justierstrukturen von Maske M und Halbleiterscheibe Hs eindeutig scharf auf die TV-Kameras TVK1 und TVK2 abzubilden. Dies soll durch eine kontinuierliche Umfokussierung der Bildinhalte von Maske M und Halbleiterscheibe Hs erreicht werden. Hierzu ist eine piezogesteuerte, shiftfreie Verstellung der Objektive Ob1 bzw. Ob2 zur kontinuierlichen Einstellung der Schärfe der Justierstrukturen auf Maske M und Halbleiterscheibe Hs in den beiden räumlich getrennten Gesichtsfeldern vorgesehen, wobei die Verstellbarkeit der Objektive Ob1 und Ob2 relativ zu den Objektebenen Oe1 und Oe2 in Figur 1 nur schematisch durch Doppelpfeile Pf1 bzw. Pf2 aufgezeigt ist. Durch softwaremäßige Auswertung der integrierter Kantensignale von Maske M und Halbleiterscheibe Hs kann dann ein Autofokus realisiert werden. Die Schärfenebene ergibt sich dabei aus der Maximierung lokaler Korrelationsfunktionen am Kantenübergang. Insbesondere kann dann ein für die Objektivverstellung vorgesehener Stellantrieb automatisch auf die optimale Schärfenebene von Maske M bzw. Halbleiterscheibe Hs eingestellt werden.

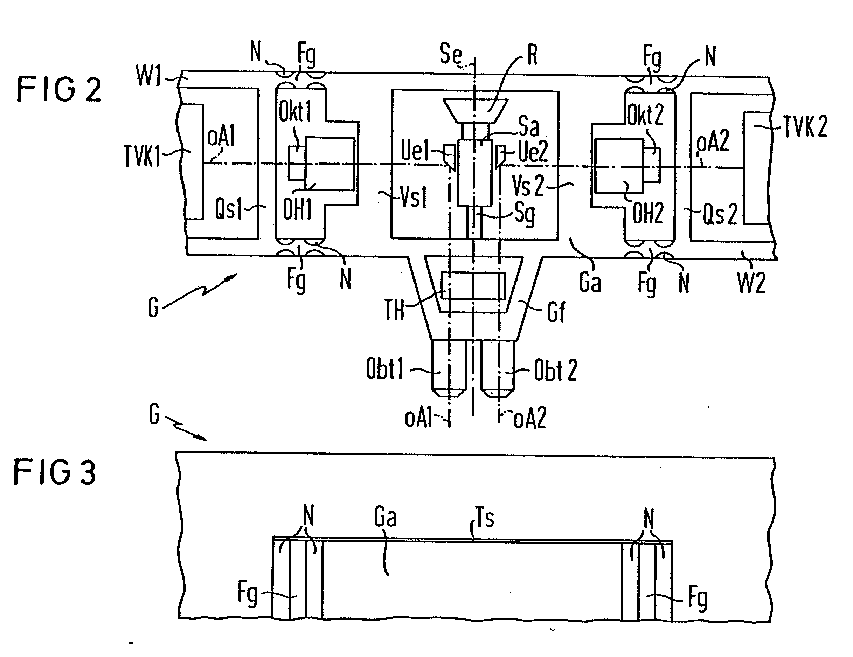

Die Figuren 2 und 3 zeigen die konstruktive Ausführung einer Einrichtung zur optischen Abbildung der Justierstrukturen von Maske und Halbleiterscheibe auf einen optischen Sensor in der Vorderansicht bzw. in der Draufsicht. Die dargestellte konstruktive Ausführung beruht dabei -bis auf einige geringfügige Abwandlungenauf der in Figur 1 aufgezeigten prinzipiellen Wirkungsweise.

Das insgesamt mit G bezeichnete und ortsfest angeordnete Gehäuse der Einrichtung ist zu einer Symmetrieebene Se spiegelsymmetrisch ausgebildet, wobei durch diese Symmetrie der Aufteilung in die beiden räumlich getrennten Gesichtsfelder Rechnung getragen wird. Die obere horizontal ausgerichtete Wandung W1 des Gehäuses G ist mit der unteren parallel dazu ausgerichteten Wandung W2 über vertikale Querstege Qs1 bzw. Qs2 verbunden, die von der Symmetrieebene Se gleich weit entfernt sind. Zwischen diesen Querstegen Qs1 und Qs2 erstreckt sich ein insgesamt mit Ga bezeichneter verstellbarer Gehäuseabschnitt, welcher durch vier paarweise auf gegenüberliegenden Seiten angeordnete Federgelenke Fg mit dem übrigen ortsfest angeordneten Gehäuse G verbunden ist. Die Verstellbarkeit dieses verstellbaren Gehäuseabschnitts Ga gegenüber dem übrigen ortsfest angeordneten Gehäuse G wird durch zwei Trennschlitze Ts ermöglicht, die in die obere Wandung W1 bzw. die untere Wandung W2 eingebracht sind und sich zwischen den entsprechenden Federgelenken Fg erstrecken. Jedes der vier Federgelenke Fg ist durch zwei im Abstand zueinander angeordnete Schwachstellen gebildet, wobei jede dieser Schwachstellen durch zwei auf gegenüberliegenden Seiten in die obere Wandung W1 bzw. die untere Wandung W2 des Gehäuses G eingebrachte Nuten N gebildet ist, welche einen halbkreisförmigen Querschnitt aufweisen. Der verstellbare Gehäuseabschnitt Ga bleibt somit mit dem übrigen ortsfest angeordneten Gehäuse G über die vier Federgelenke Fg einstückig verbunden. Wie aus Figur 3 ersichtlich ist, nimmt der verstellbare Gehäuseabschnitt Ga nur einen Teil der Tiefe des Gehäuses G ein. Außerdem erstrecken sich im Bereich des verstellbaren Gehäuseabschnitts Ga zwischen der oberen Wandung W1 und der unteren Wandung W2 kräftig ausgebildete Versteifungsstege Vs1 und Vs2, welche von der Symmetrieebene Se wiederum gleich weit entfernt sind.

An die Unterseite des verstellbaren Gehäuseabschnitts Ga ist ein im Querschnitt trapezförmiger und innen hohler Gehäuse-fortsatz Gf angeformt, welcher auf seiner Unterseite einen ersten Objektivtubus Obt1 und einen gleich weit von der Symmetrieebene entfernten Objektivtubus Obt2 trägt. In dem Objektivtubus Obt1 befindet sich das in Figur 1 dargestellte Objektiv Ob1 bzw. ein entsprechendes Linsensystem, während sich in dem Objektivtubus Obt2 das in Figur 1 dargestellte Objektiv Ob2 bzw. ein entsprechendes Linsensystem befindet. Die in Figur 1 dargestellten Tubuslinsen T11 und T12 sind in einer gemeinsamen Tubuslinsen-Halterung TH angeordnet, welche in den Hohlraum des Gehäusefortsatzes Gf ragt und in einem gleich ausgebildeten und durch den Trennschlitz Ts getrennten Gehäusefartsatz des übrigen ortsfest angeordneten Gehäuses G verankert ist.

Abweichend von der in Figur 1 dargestellten prinzipiellen Wirkungsweise sind bei der in Figur 2 aufgezeigten konstruktiven Ausführung die Umlenkeinrichtungen Ue1 und Ue2 nicht zwischen den Okularen Ok1 bzw. Ok2 und den TV-Kameras TVK1 bzw. TVK2 sondern zwischen den Tubuslinsen T11 bzw. T12 und den Okularen Ok1 bzw. Ok2 angeordnet. Die hier als Prismen ausgebildeten und im ortsfesten Gehäuse G verankerten Umlenkeinrichtungen Ue1 und Ue2 ragen im Bereich zwischen den Versteifungsstegen Vs1 und Vs2 in den verstellbaren Gehäuseabschnitt Ga. Die den beiden Gesichtsfeldern zugeordneten und zunächst vertikal verlaufenden optischen Achsen oA1 und oA2 nehmen im Anschluß an die Umlenkeinrichtungen Ue1 bzw. Ue2 einen horizontalen Verlauf. Nach den Umlenkeinrichtungen Ue1 bzw. Ue2 sind dann die den Okularen Ok1 bzw. Ok2 (vgl. Fig. 1) entsprechenden Okulare oder Linsensysteme angeordnet und in einem Okulartubus Okt1 bzw. einem Okulartubus Okt2 gehalten. Der Okulartubus Okt1 ist dabei in einer zwischen dem Quersteg Qs1 und dem Versteifungssteg Vs1 angeordneten und im ortsfesten Gehäuse G verankerten Okulartubus-Halterung OH1 befestigt, während der Okulartubus Okt2 in entsprechender Weise in einer zwischen dem Quersteg Qs2 und dem Versteigungssteg Vs2 angeordneten und im ortsfesten Gehäuse G verankerten Okulartubus-Halterung OH2 befestigt ist. Im weiteren Verlauf der horizontalen Abschnitte der optischen Achsen oA1 bzw. oA2 sind dann nach den Querstegen Qs1 bzw. Qs2 die TV-Kameras TVK1 bzw. TVK2 angeordnet, welche mit dem ortsfesten Gehäuse G fest, aber in bezug auf die optischen Achsen oA1 bzw. oA2 justierbar verbunden sind.

Die shiftfreie Verstellung der Objektive Ob1 und Ob2 (vgl. Fig. 1) in der vertikalen Richtung der optischen Achsen oA1 bzw. oA2 auf die jeweils optimale Schärfenebene erfolgt mit Hilfe eines als Piezostellantrieb ausgebildeten Stellantriebes Sa, welcher an dem verstellbaren Gehäuseabschnitt Ga angreift und an dem ortsfesten Gehäuse G abgestützt ist. Um eine möglichst kompakte Bauweise zu erreichen, ist der Stellantrieb Sa in dem verstellbaren Gehäuseabschnitt Ga genau zwischen den Umlenkeinrichtungen Ue1 und Ue2 angeordnet und an einer in den verstellbaren Gehäuseabschnitt Ga ragenden, sehr steif ausgebildeten Rippe R des übrigen ortsfesten Gehäuses G abgestützt. Der Stellantrieb Sa ist dabei beispielsweise mit der Rippe R fest verschraubt, während sein bewegliches Stellglied Sg an der unteren Wandung W2 des verstellbaren Gehäuseabschnitts Ga angreift und eine elastische, shiftfreie Auslenkung des verstellbaren Gehäuseabschnitts Ga und damit auch des Objektivtubus Obt1 bzw. des Objektivtubus Obt2 bewirken kann.

Zur Vereinfachung der zeichnerischen Darstellung wurde in Figur 1 und in den Figuren 2 und 3 die Beleuchtungsanordnung weggelassen. Die Beleuchtung von Halbleiterscheibe Hs und Maske M (vgl. Fig. 1) erfolgt nach Art einer Mikroskopbeleuchtung, insbesondere nach dem Köhlerschen Beleuchtungsprinzip, bei welchem das Objekt von Parallelstrahlen beleuchtet wird. Die Einbringung des Lichts in die Einrichtung erfolgt dabei über Lichtleiter, um innerhalb der Einrichtung die Entwicklung von Wärme und einen entsprechenden thermischen Verzug zu vermeiden.

Die in den Figuren 2 und 3 dargestellte Verstellung der Objektive Ob1 und Ob2 (vgl. Fig. 1) über den verstellbaren Gehäuseabschnitt Ga ermöglicht eine absolut spielfreie Verstellung mit einer Positionierwiederholbarkeit von $\pm 0,01$ μm bei einer statistischen Sicherheit von 95 %. Im übrigen ermöglicht die dargestellte Einrichtung eine Bestimmung der Relativlage von Maske M und Halbleiterscheibe Hs mit äußerst geringen Meßunsicherheiten von 0,01 μm bzw. $\pm 1$ s.

Bei der in den Figuren 2 und 3 dargestellten Einrichtung werden mit dem verstellbaren Gehäuseabschnitt Ga nur die Objektive Ob1 und Ob2 (vgl. Fig. 1) verstellt. Es kann aber auch zweckmäßig sein, mit dem verstellbaren Gehäuseabschnitt Ga sämtliche optischen Bauelemente der Einrichtung einschließlich der TV-Kameras TVK1 und TVKS zu verstellen. In diesem Fall wird die Justierung der gesamten Einrichtung einfacher, da die Bewegungsrichtung der Objektive Ob1 und Ob2 (vgl. Fig. 1) nicht exakt parallel mit der optischen Achse oA1 bzw. oA2 verlaufen muß. ·

## Patentansprüche

1. Einrichtung zur optischen Abbildung zweier in verschiedenen Objektebenen (Oe1, Oe2) angeordneter Objekte auf einen optischen Sensor (TVK1, TVK2), bei welcher zumindest ein Objektiv (Ob1, Ob2) mit Hilfe eines Stellantriebes (Sa) relativ zu den Objektebenen verstellbar ist, dadurch gekennzeichnet, daß der Stellantrieb (Sa) an einem Ortsfesten Gehäuse (G) abgestützt ist und an einem relativ zu den Objektebenen (Oe1, Oe2) verstellbaren und zumindest das Objektiv (Ob1, Ob2) tragenden Gehäuseabschnitt (Ga) angreift, daß das ortsfeste Gehäuse (G) und der verstellbare Gehäuseabschnitt (Ga) einstückigausgebildet sind und daß der verstellbare Gehäuseabschnitt (Ga) mit dem ortsfesten Gehäuse (G) über symmetrisch zur optischen Achse angeordneten Federgelenken (Fg) verbunden ist, die durch elastisch deformierbare Schwachstellen des Gehäuses (G) gebildet sind.

2. Einrichtung nach Anspruch 1, dadurch gekennzeichnet, daß mindestens vier, paarweise auf gegenüberliegenden Seiten des verstellbaren Gehäuseabschnitts (Ga) angeordnete Federgelenke (Fg) vorgesehen sind.

3. Einrichtung nach Anspruch 1 oder 2, dadurch gekennzeichnet, daß jedes Federgelenk (Fg) durch zwei im Abstand zueinander angeordnete Schwachstellen gebildet ist, wobei jede Schwachstelle durch auf gegenüberliegenden Seiten in die Wandung (W1, W2) des Gehäuses (G) eingebrachte Nuten (N) gebildet ist.

4. Einrichtung nach Anspruch 3, dadurch gekennzeichnet, daß die Nuten (N) einen halbkreisförmigen Querschnitt aufweisen.

5. Einrichtung nach einem der vorhergehenden Ansprüche, dadurch gekennzeichnet, daß zwischen den verstellbaren Gehäuseabschnitt (Ga) und das übrige Gehäuse (G) Trennschlitze (Ts) eingebracht sind, die sich jeweils zwischen zwei Federgelenken (Fg) erstrecken.

6. Einrichtung nach Anspruch 6, dadurch gekennzeichnet, daß der Stellantrieb (Sa) in dem verstellbaren Gehäuseabschnitt (Ga) angeordnet und an einer in den verstellbaren Gehäuseabschnitt (Ga) ragenden Rippe (R) des übrigen Gehäuses (G) abgestützt ist.

7. Einrichtung nach einem der vorhergehenden Ansprüche, dadurch gekennzeichnet, daß als Stellantrieb (Sa) ein Piezostellantrieb vorgesehen ist.

8. Einrichtung nach einem der vorhergehenden Ansprüche, dadurch gekennzeichnet, daß ein Objektiv (Ob1, Ob2) mit unendlicher Bildweite vorgesehen ist, welchem eine von dem ortsfest angeordneten Gehäuse (G) getragene Tubuslinse (T11, T12) nachgeschaltet ist.

9. Einrichtung nach einem der vorhergehenden Ansprüche, dadurch gekennzeichnet, daß die Objekte in zwei räumlich getrennten Gesichtsfeldern über zwei Objektive (Ob1, Ob2) auf zwei optische Sensoren abbildbar sind, wobei der Stellantrieb (Sa) mittig zwischen den optischen Achsen an dem beide Objektive (Ob1, Ob2) tragenden verstellbaren Gehäuseabschnitt angreift.

## Claims

1. A device for the optical reproduction of two objects, arranged in different object planes (Oel, Oe2) onto an optical sensor (TVK1, TVK2), in which at least one objective (Ob1, Ob2) can be adjusted relative to the object plane by means of an actuating drive (Sa), characterised in that the actuating drive (Sa) is supported by a stationary housing (G) and acts upon a housing section (Ga) which is adjustable relative to the object planes (Oe1, Oe2) and at least bears the objective (Ob1, Ob2) ;

that the stationary housing (G) and the adjustable housing section (Ga) are designed so as to be integral ; and

that the adjustable housing section (Ga) is connected to the stationary housing (G) via flexible articulations (Fg) which are symmetrical in relation to the optical axis and which are formed by elastically deformable weak points of the housing (G).

2. A device as claimed in Claim 1, characterised in that at least four flexible articulations (Fg) are provided which are arranged in pairs on opposite sides of the adjustable housing section (Ga).

3. A device as claimed in Claim 1 or 2, characterised in that each flexible articulation (Fg) is formed by two weak points arranged at a distance from one another, where each weak point is formed by grooves (N) which are introduced into the walls (W1, W2) of the housing (G) on opposite sides.

4. A device as claimed in Claim 3, characterised in that the grooves (N) have a semi-circular cross-section.

5. A device as claimed in one of the preceding claims, characterised in that separating slots (Ts), which each extend between two flexible articulations (Fg), are introduced between the adjustable housing section (Ga) and the remainder of the housing (G).

6. A device as claimed in Claim 6, characterised in that the actuating drive (Sa) is arranged in the adjustable housing section (Ga) and is supported by a rib (R), which projects into the adjustable housing section (Ga), of the remainder of the housing (G).

7. A device as claimed in one of the preceding claims, characterised in that the actuating drive (Sa) consists of a piezo-electric actuating unit.

8. A device as claimed in one of the preceding claims, characterised in that an objective (Ob1, Ob2) with an infinite focal length is provided, which is connected at its output end to a tubular lens (T11, T12) supported by the stationary housing (G).

9. A device as claimed in one of the preceding claims, characterised in that the objects can be reproduced in two separate fields of vision via two objectives (Ob1, Ob2) on to two optical sensors, where the actuating drive (Sa) acts upon the adjustable housing section, which bears the two objectives (Ob1, Ob2), centrally between the optical axes.

**Revendications**

1. Dispositif pour la reproduction optique de deux objets disposés dans des plans-objets différents (Oe1, Oe2), sur un capteur optique (TVK1, TVK2), dans lequel au moins un objectif (Ob1, Ob2) est mobile par rapport aux plans-objets à l'aide d'un mécanisme de réglage (Sa), caractérisé en ce que le mécanisme de réglage (Sa) est appuyé sur un boîtier (G) dont la position est fixe et attaque une section de boîtier (Ga) mobile par rapport aux plans-objets et portant au moins l'objectif (Ob1, Ob2) , que le boîtier (G) dont la position est fixe et la section de boîtier (Ga) mobile sont réalisés en une seule pièce et que la section de boîtier (Ga) mobile est reliée au boîtier dont la position est fixe, par l'intermédiaire d'articulations élastiques (Fg), disposées symétriquement par rapport à l'axe optique, et qui sont réalisées par des points faibles du boîtier (G) qui sont déformables élastiquement.

2. Dispositif selon la revendication 1, caractérisé en ce que sont prévus au moins quatre articulations élastiques (Fg) disposées, par paires sur des côtés opposés de la section de boîtier (Ga) mobile.

3. Dispositif selon la revendication 1 ou 2, caractérisé en ce que chaque articulation élastique (Fg) est réalisé par deux points faibles situés à distance l'un de l'autre, chaque point faible étant formé par des gorges (N) ménagées sur des côtés opposés dans les parois (W1, W2) du boîtier (G).

4. Dispositif selon la revendication 3, caractérisé. en ce que les gorges (N) présentent une section transversale en forme de demi-cercle.

5. Dispositif selon une des revendications précédentes, caractérisé en ce que, entre la section de boîtier (Ga) mobile et l'autre boîtier (G) sont réalisées des fentes de séparation (Ts) qui s'étendent chacune entre deux articulations élastiques (Fg).

6. Dispositif selon la revendication 6, caractérisé en ce que le mécanisme de réglage (Sa) est ménagé dans la section de boîtier (Ga) mobile et est appuyé sur une nervure (R) de l'autre boîtier (G), qui pénètre dans la section de boîtier (Ga) mobile.

7. Dispositif selon une des revendications précédentes, caractérisé en ce qu'un mécanisme de réglage piézo-électrique est prévu en tant que mécanisme de réglage (Sa).

8. Dispositif selon une des revendications précédentes, caractérisé en ce qu'est prévu un objectif (Ob1, Ob2) à profondeur de champ infinie, qui est monté en aval d'une lentille de tube (T11, T12) portée par le boîtier (G) ménagé en position fixe.

9. Dispositif selon une des revendications précédentes, caractérisé en ce que les objets peuvent être représentés en deux champs de vision séparés dans l'espace, sur deux capteurs optiques, par l'intermédiaire de deux objectifs (Ob1, Ob2), le mécanisme de réglage (Sa) étant appliqué, au milieu entre les axes optiques, sur la section de boîtier mobile portant les deux objectifs (Ob1, Ob2).

FIG 1

Le

Bv

Δx, Δy, Δφ

Bs1

Bs2

Ue1

Ue2

TVK1

TVK2

Ok1

Ok2

TVM1

TVM2

T11

T12

Pf1

Pf2

Ob1

Ob2

Oe2

M

JkM2

Pf

JkM1

x

Pa

Oe1

y

φ

Hs

JkS1

JkS2

Pv

0 185 263

FIG 2

FIG 3